# EUROPÄISCHE PATENTSCHRIFT

(11) **EP 1 014 578 B1**
(45) Veröffentlichungstag und Bekanntmachung des Hinweises auf die Patenterteilung: **27.02.2008**
(21) Anmeldenummer: 99124521.8
(22) Anmeldetag: 09.12.1999
(51) Int. Cl.: H03J 9/00

(54) **Fernbedienungsgeber mit einem Speicher für Senderbezeichnungen**
Remote control device with a memory for channel indicators
Dispositif de télécommande avec une mémoire pour la désignation des stations

(30) Priorität: 23.12.1998 DE 19859705
(43) Veröffentlichungstag der Anmeldung: 28.06.2000
(73) Patentinhaber: Grundig Multimedia B.V., 1083 HJ Amsterdam (NL)
(72) Erfinder: Kornhaas, Wolfgang, Grundig AG, 90762 Fürth (DE)
(74) Vertreter: Pröll, Jürgen

(56) Entgegenhaltungen:
- DE-A- 3 640 437
- GB-A- 2 215 928

## Beschreibung

Die Erfindung betrifft einen Fernbedienungsgeber mit den im Oberbegriff des Anspruchs 1 angegebenen Merkmalen.

Um mittels bekannter Fernbedienungsgeber ein bestimmtes Rundfunkprogramm anzuwählen, muß der Benutzer entweder die diesem Rundfunkprogramm zugehörige Stationstastennummer auswendig wissen oder er muß die genannte Rundfunkprogrammanwahl durch ein Zappen unter Ver-wendung der +/- - Tasten des Fernbedienungsgebers durchführen. Alternativ dazu ist es auch möglich, daß sich der Benutzer die Stationstastennummer und die jeweils zugehörige Senderbezeichnung auf einem Blatt Papier notiert und vor der genannten Anwahl eines gewünschten Rundfunkprogrammes auf diesem Blatt Papier nachschaut, wie die zugehörige Stationstastennummer lautet.

Beim Empfang von ausschließlich terrestrischen Sendern sind alle diese Methoden wegen der geringen Anzahl von empfangbaren Sendern ohne größere Schwierigkeiten durchführbar.

Zeitaufwendiger und umständlicher wird die Anwahl eines gewünschten Rundfunkprogrammes dann, wenn ein Rundfunkempfang über eine Kabelanlage erfolgt. In diesem Fall sind im allgemeinen bereits über 30 Sender empfangbar. Bei dieser Anzahl von empfangbaren Sendern ist es bereits sehr schwierig, sich zu jedem der empfangbaren Sender die jeweils zugehörige Stationstastennummer zu merken. Die Anwahl eines Aus DE 36 40 437-A1 ist ein programmierbares Gerät zum Einstellen eines Empfangsgerätes der Unterhaltungselektronik offenbart. Das Gerät weißt eine Stromversorgung, einen Mikroprozessor, mindestens einen Speicher, ein Display und eine Eingabetastatur sowie eine Übertragungseinrichtung auf. Das programmierbare Gerät ist in der Lage, auf dem Display in numerischer bzw. alphanumerischer Form Senderdaten anzuzeigen. gewünschten Rundfunkprogrammes durch ein Zappen unter Verwendung der +/- - Tasten des Fernbedienungsgebers nimmt bei dieser Anzahl von empfangbaren Sendern bereits einen größeren Zeitraum in Anspruch. Auch das Erstellen einer handschriftlichen Senderliste ist mit großem Aufwand verbunden.

Noch unübersichtlicher wird die Lage beim Empfang von Signalen über eine Satellitenempfangsanlage, da in diesem Fall in der Regel weit über 100 verschiedene Rundfunkprogramme empfangen werden können.

Um dieser Problematik gerecht zu werden, wurden bereits Satellitenempfänger vorgeschlagen, die eine OSD (on-screen-display)-Benutzerführung aufweisen, um dem Benutzer eine Übersicht über die empfangbaren Programme zu geben.

Der Erfindung liegt die Aufgabe zugrunde, einen neuen Weg aufzuzeigen, wie beim Vorliegen einer Vielzahl von empfangbaren Sendern eine Programmumschaltung durch den Benutzer auf einfache Weise realisierbar ist.

Diese Aufgabe wird durch einen Fernbedienungsgeber mit den im Anspruch 1 angegebenen Merkmalen gelöst. Vorteilhafte Ausgestaltungen und Weiterbildungen ergeben sich aus den abhängigen Ansprüchen.

Die Vorteile der Erfindung bestehen insbesondere darin, daß dem Benutzer auf dem Display eines Fernbedienungsgebers Senderbezeichnungen angezeigt werden können, unter deren Verwendung der Benutzer mittels des Fernbedienungsgebers Umschaltsignale an ein jeweiliges Empfangsgerät aussenden kann. Der Benutzer hat die Möglichkeit, durch die abgespeicherten Senderbezeichnungen zu blättern und beim Auffinden der gewünschten Senderbezeichnung ein entsprechendes Umschaltsignal auszulösen. Zu diesem Blättern durch die abgespeicherten Senderbezeichnungen ist keine Umschaltung der Abstimmung eines Empfangsgerätes notwendig. Folglich wird für das genannte Blättern wesentlich weniger Zeit benötigt als bei einem Zappen durch die empfangbaren Sender. Alternativ dazu hat der Benutzer auch die Möglichkeit, die Zeit zum Umschalten auf einen gewünschten Sender durch die Eingabe des ersten Buchstabens der zugehörigen Senderbezeichnung zu verkürzen. Bei einer derartigen Eingabe des ersten Buchstabens sorgt der Mikrocomputer des Fernbedienungsgebers für einen entsprechenden Sprung innerhalb des nichtflüchtigen Speichers zu denjenigen Senderbezeichnungen, die mit dem genannten Buchstaben beginnen. Die Eingabe der Senderbezeichnungen in den nichtflüchtigen Speicher des Fernbedienungsgebers erfolgt entweder manuell mittels der Tasten des Fernbedienungsgebers oder es erfolgt eine Übernahme dieser Senderbezeichnungen aus dem Senderspeicher des zu steuernden Gerätes, in welchem diese Senderbezeichnungen bereits abgespeichert sind.

Weitere vorteilhafte Eigenschaften der Erfindung ergeben sich aus der Erläuterung eines Ausführungsbeispiels anhand der Figuren. Es zeigt:
- Figur 1 ein Blockschaltbild eines Fernbedienungsgebers gemäß der Erfindung;
- Figur 2 eine Skizze der Vorderansicht eines Fernbedienungsgebers gemäß der Erfindung und
- Figur 3 eine Skizze zur Erläuterung einer Senderanwahl mittels des Fernbedienungsgebers.

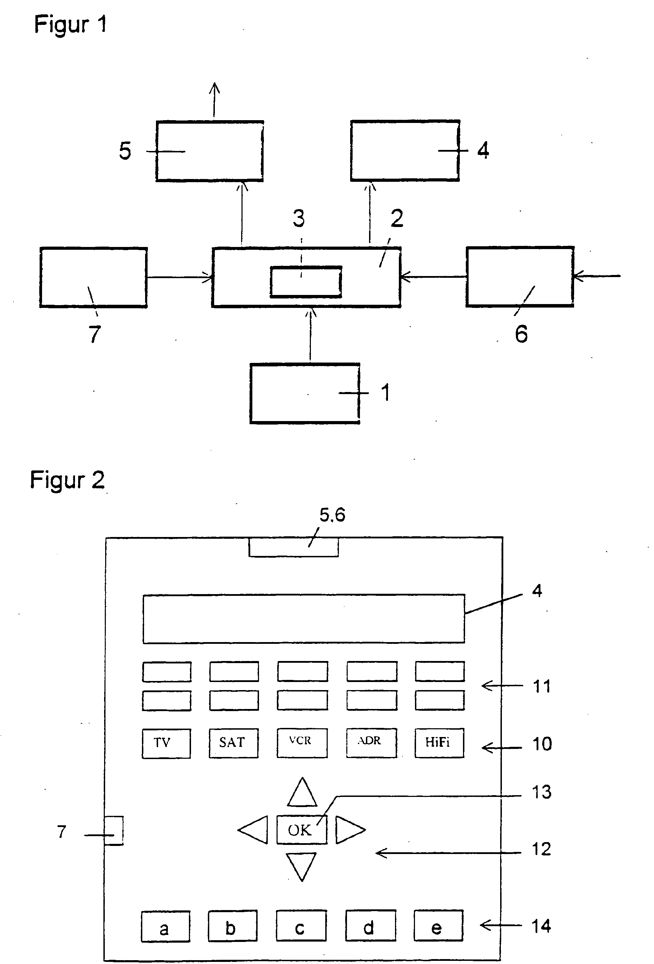

Die Figur 1 zeigt ein Blockschaltbild eines Fernbedienungsgebers gemäß der Erfindung. Dieser hat eine Tastatur 1, welche Programmquellenauswahltasten, Zifferntasten, Cursorsteuertasten, eine Bestätigungstaste und eine oder mehrere Sondertasten aufweist. Weiterhin enthält der gezeigte Fernbedienungsgeber als zentrale Steuereinheit einen Mikrocomputer 2, zu welchem ein nichtflüchtiger Speicher 3 gehört. Dieser nichtflüchtige Speicher 3 ist - wie unten noch erläutert wird - zur Abspeicherung von Daten vorgesehen, die Senderbezeichnungen entsprechen. Derartige Senderbezeichnungen sind beispielsweise alphanumerische Sendernamen wie ARD, ZDF, BR3, SAT1, RTL, usw., oder auch Senderlogos, die graphischen Senderbezeichnungen entsprechen. Ferner weist der gezeigte Fernbedienungsgebers eine Anzeigeeinheit 4 auf, bei er es sich vorzugsweise um ein ein- oder mehrzeiliges LCD handelt. Diese Anzeigeeinheit 4 ist unter anderem zur Anzeige der genannten Senderbezeichnungen vorgesehen. Die im Fernbedienungsgeber unter Steuerung des Mikrocomputers 2 erzeugten Fernbedienbefehle werden über einen Infrarotsender 5 an ein zu bedienendes Gerät der Unterhaltungselektronik ausgestrahlt. Ein derartiges Gerät ist beispielsweise ein Fernsehgerät, ein Videorecorder, ein Hörrundfunkgerät, ein Satellitenempfänger, ein ADR (Astra-Digital-Radio)-Empfangsgerät oder ein anderes HiFi-Gerät.

Die Eingabe der den Senderbezeichnungen entsprechenden Daten erfolgt entweder manuell mittels der Tastatur 1 oder automatisch über einen Eingangsanschluß, bei welchem es sich um einen Infrarotempfänger 6 oder um eine Anschlußbuchse 7, die zum Anschluß eines Verbindungskabels vorgesehen ist, handelt.

Um eine manuelle Dateneingabe mittels der Tastatur 1 zu ermöglichen, sind jeder der Zifferntasten des Fernbedienungsgebers mehrere Buchstaben des Alphabets zugeordnet, so daß die jeweilige Zifferntaste bei der manuellen Eingabe einer Senderbezeichnung nicht nur zur Eingabe der jeweiligen Ziffer, sondern auch zur Eingabe mehrerer Buchstaben des Alphabets verwendet werden kann. Beispielsweise sind der Zifferntaste "1" auch die Buchstaben A, B und C des Alphabets zugeordnet. Um dies für den Benutzer kenntlich zu machen, sind diese Buchstaben zusätzlich zur jeweiligen Ziffer in vorteilhafter Weise auf oder unterhalb der jeweiligen Zifferntaste angebracht.

Die Eingabe des Buchstabens B im Rahmen der Eingabe einer Senderbezeichnung erfolgt dadurch, daß bei der Eingabe zunächst durch ein erstes Betätigen der Zifferntaste "1" die Ziffer 1 angewählt wird, die dann unter Steuerung des Mikrocomputers 2 auf dem LCD 4 angezeigt wird. Wird dann die Zifferntaste "1" erneut betätigt, dann wechselt die Anzeige auf den Buchstaben "A" und bei einem nochmaligen Drücken auf den Buchstaben "B". Zur Eingabe dieses Buchstabens wird schließlich eine Bestätigungstaste des Fernbedienungsgebers betätigt, bei der es sich beim gezeigten Ausführungsbeispiel um die in der Mitte zwischen den Cursorsteuertasten angeordnete OK-Taste handelt.

Zur Eingabe des nächsten Buchstabens der Senderbezeichnung wird dann mittels der rechten Cursorsteuertaste die Buchstabenposition um eine Stelle nach rechts verschoben, dann die jeweils notwendige Zifferntaste angewählt und durch ein ein- oder mehrmaliges Betätigen dieser Zifferntaste der benötigte Buchstabe oder die benötigte Ziffer angewählt und bestätigt.

Bei dieser manuellen Eingabe der Senderbezeichnungen erfolgt zusätzlich zur Eingabe der jeweiligen Senderbezeichnung die Eingabe einer dieser Senderbezeichnung zugehörigen Programmplatznummer. Die Programmplatznummer wird so gewählt, daß sie mit der Programmplatznummer im Senderspeicher eines angeschlossenen Gerätes, beispielsweise Fernsehgerätes, übereinstimmt.

Auf diese Weise kann ein Benutzer im Sinne einer manuellen Eingabe für eine große Anzahl von Sendern die jeweilige Senderbezeichnung und die zugehörige Programmplatznummer eingeben. Dies entspricht einer benutzerseitigen Erstellung einer Senderdatenbank, deren Daten im nichtflüchtigen Speicher 3 des Mikrocomputers 2 abgespeichert werden und dem Benutzer nach der Abspeicherung für eine Programm- bzw. Senderanwahl im normalen Gerätebetrieb zur Verfügung stehen.

Alternativ dazu kann die Eingabe der den Senderbezeichnungen und Programmplatznummern entsprechenden Daten auch - wie bereits oben angegeben - automatisch über den Infrarotempfänger 6 oder die Anschlußbuchse 7 erfolgen. Diese automatische Eingabe wird beispielsweise dadurch ausgelöst, daß eine erste der genannten Sondertasten oder auch eine bestimmte Tastenkombination betätigt wird. Diese Betätigung wird vom Mikrocomputer 2 erkannt und in ein zugehöriges Befehlssignal umgesetzt, welches dann über den Infrarotsender 5 an das Fernsehgerät übermittelt wird. Dort gelangt das genannte Befehlssignal über einen Infrarotempfänger an den Mikrocomputer des Fernsehgerätes. Dieser adressiert dann den Senderspeicher des Fernsehgerätes derart, daß die dort abgespeicherten Senderbezeichnungen ausgelesen und inklusive zugehöriger Programmplatznummern in Form eines Infrarottelegrammes, welches die Daten der kompletten Senderliste bzw. Senderdatenbank enthält, zum Fernbedienungsgeber übertragen werden. Dort gelangen sie über den Infrarotempfänger 6 in den nichtflüchtigen Speicher 3.

Alternativ zu der vorstehend beschr:ebenen Infrarotübertragung kann die Übertragung der SenderdatenbanK vcm Fernsehempfänger zum Fernbedienungsgeber auch unter Verwendung eines Signalkabels erfolgen, welches mit der Anschlußbuchse 7 des Fernbedienungsgebers verbunden ist.

Die Figur 2 zeigt eine Skizze der Vorderansicht eines Fernbedienungsgebers gemäß der Erfindung. Aus dieser Figur sind die Programmquellenauswahltasten 10, die Zifferntasten 11, die Cursorsteuertasten 12, die Bestätigungstaste 13, die Sondertasten 14, die Anschlußbuchse 7, der Infrarotsender und Infrarotempfänger 5, 6 und das LCD 4 ersichtlich.

Die oben beschriebene manuelle Eingabe der Senderbezeichnungen wird beispielsweise durch eine gemeinsame Betätigung der Sondertasten a und b aktiviert. Wird nach dieser Aktivierung die Zifferntaste "1" betätigt, dann wird auf dem Display 4 zunächst die Ziffer 1 angezeigt. Danach kann der Benutzer auf die oben beschriebene Weise den Buchstaben B anwählen und bestätigen, danach mittels der rechten Cursorsteuertaste die nächste Buchstabenposition anwählen, usw., bis die gewünschte Senderbezeichnung und die zugehörige Stationstastennummer eingegeben sind.

Die oben beschriebene automatische Eingabe der Senderbezeichnungen wird beispielsweise durch eine gemeinsame Betätigung der Sondertasten c und d aktiviert. Nach dieser Aktivierung erfolgt auf die oben beschriebene Weise die automatische Übertragung der kompletten Senderdatenbank aus dem Fernsehempfänger in den Fernbedienungsgeber.

Ist der nichtflüchtige Speicher 3 mit den genannten Daten gefüllt, dann besteht für den Benutzer die Möglichkeit, die Reihenfolge der abgespeicherten Senderbezeichnungen nach seinen eigenen Vorstellungen zu sortieren. Diese Betriebsart "Sendersortierung" wird durch gemeinsame Betätigung der Sondertasten a und e aktiviert. Zur Sendersortierung wird zunächst ein zu verschiebender Programmplatz markiert, indem er angewählt und durch eine Betätigung der OK-Taste 13 bestätigt wird. Danach wird mittels der Cursorsteuertasten der Speicher solange durchsucht, bis diejenige Senderbezeichnung im Display 4 angezeigt wird, nach welcher die vorher ausgewählte Senderbezeichnung eingefügt werden soll. Durch eine Bestätigung mit der OK-Taste 13 wird die vorher angewählte Senderbezeichnung an der gewünschten Stelle eingefügt, wobei eine entsprechende Umsortierung des gesamten Speicherinhalts automatisch unter Steuerung des Mikrocomputers 2 erfolgt.

Alternativ dazu kann die Abspeicherung der Senderbezeichnungen im nichtflüchtigen Speicher 3 auch unter Steuerung des Mikrocomputers 2 so erfolgen, daß die Senderbezeichnungen im Speicher in alphabetischer Reihenfolge vorliegen.

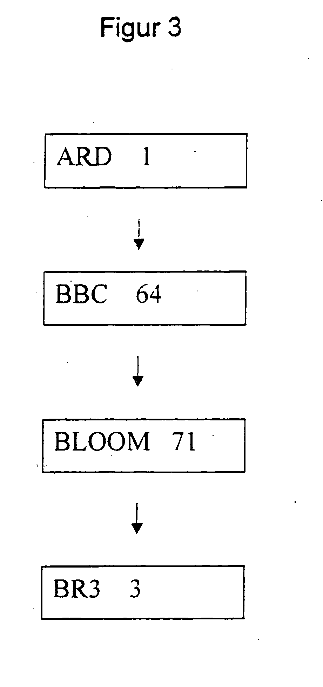

Eine Sendersuche kann nach erfolgter Programmierung des nichtflüchtigen Speichers 3 wie folgt durchgeführt werden:
Eine erste Möglichkeit besteht darin, einen gewünschten Sender, beispielsweise BR3, unter Verwendung der Cursorsteuertasten 12 aufzusuchen. Ein Beispiel dafür wird anhand der Figur 3 näher erläutert In einem ersten Schritt wird durch gemeinsame Betätigung der Sondertasten a und c die Funktion "SENDERTABELLE ANZEIGEN" aktiviert. Dabei erscheint die alphabetisch erste Senderbezeichnung ARD und die zugehörige Programmplatznummer 1 auf der Anzeige 4. Im nächsten Schritt betätigt der Benutzer die obere Cursorsteuertaste, um zum nächsten Buchstaben des Alphabets zu wechseln. Daraufhin erscheint beispielsweise die Senderbezeichnung BBC und die zugehörige Programmplatznummer 64 auf der Anzeige 4. Um einen weiteren Sender mit demselben Anfangsbuchstaben zu finden, wird im nächsten Schritt die rechte Cursorsteuertaste betätigt. Dies führt dazu, daß die Senderbezeichnung BLOOM und die zugehörige Programmplatznummer 71 auf der Anzeige 4 dargestellt werden. Ein weiteres Drücken der rechten Cursorsteuertaste führt schließlich zum Auffinden des gewünschten Senders bzw. zur Anzeige der Senderbezeichnung BR3 und der zugehörigen Programmplatznummer 3 auf dem Display 4.

Hat man auf diese Weise den gesuchten Sender gefunden, dann wird zum Umschalten des Fernsehempfängers auf den genannten Sender die OK-Taste 13 betätigt. Dies wird vom Mikrocomputer 2 erkannt, der daraufhin ein zugehöriges Befehlssignal generiert und über den Infrarotsender 5 an das Fernsehgerät aussendet. Dessen Mikrocomputer sorgt dann für eine entsprechende Ansteuerung des Empfangsteils des Fernsehgerätes, um auf den gewünschten Sender umzuschalten.

Eine zweite Möglichkeit zur Sendersuche besteht darin, nach der Aktivierung der Funktion "SENDERTABELLE ANZEIGEN", wonach auf der Anzeige 4 die alphabetisch erste Senderbezeichnung ARD und die zugehörige Programmplatznummer 1 angezeigt werden, den Anfangsbuchstaben des gewünschten Senders einzugeben, beispielsweise W. Dieser wird dann auf dem Display angezeigt. Zusätzlich zeigt ein Cursor im Display auf die Position des nächsten Buchstabens. Nach Eingabe des nächsten Buchstabens springt der Cursor weiter, usw.

Eine auf diese Weise anzuwählende Senderbezeichnung und die zugehörige Programmplatznummer werden dann komplett angezeigt, wenn entweder
- die Senderbezeichnung vollständig eingegeben und gegebenenfalls mit der OK-Taste 13 bestätigt wurde oder
- die bisher angegebenen Buchstaben dem Mikrocomputer 2 eine eindeutige Identifizierung des gewünschten Senders erlauben.

Hat man auf diese Weise den gesuchten Sender gefunden, dann wird zum Umschalten des Fernsehempfängers auf den genannten Sender die OK-Taste 13 betätigt. Die weitere Signalverarbeitung erfolgt dann so, wie es oben im Zusammenhang mit der ersten Möglichkeit zur Sendersuche beschrieben wurde.

Ein Vorteil der Erfindung besteht darin, daß stets die komplette Senderdatenbank für ein oder mehrere Geräte im Fernbedienungsgeber abespeichert ist. Der Benutzer kann auch unabhängig von den genannten Geräten, die im ausgeschalteten Zustand sein können, die Senderdatenbank durchsuchen und bei Bedarf aktualisieren.

Besonders vorteilhaft ist es, nach einem Neukauf eines Fernsehgerätes zunächst den Senderspeicher des Fernsehgerätes durch einen automatischen Suchlauf zu füllen, wobei die Senderbezeichnungen bzw. Senderlogos dem übertragenen Signal entnommen werden, danach durch eine automatische Sendersortierung jeder Senderbezeichnung automatisch eine Programmplatznummer zuzuordnen und schließlich nach einer Eingabe eines Aktivierungsbefehls mittels des Fernbedienungsgebers die Senderdatenbank in den nichtflüchtigen Speicher des Fernbedienungsgebers zu übernehmen.

## Patentansprüche

1. Fernbedienungsgeber, welcher Zifferntasten, Steuertasten, einen Mikrocomputer, ein Display und einen Infrarotsender und einen nichtflüchtigen Speicher (3) zur Abspeicherung von Senderbezeichnungen entsprechenden Daten aufweist,
**dadurch gekennzeichnet, dass**
die Senderbezeichnungen in graphischer Form als Logo auf dem Display (4) darstellbar sind.

2. Fernbedienungsgeber nach Anspruch 1,
**dadurch gekennzeichnet, dass**
er eine Taste aufweist, bei deren Betätigung ein Programmumschaltdaten aufweisendes Infrarotbefehlssignal ausgesendet wird, welche Programmumschaltdaten einer momentan am Display (4) dargestellten Senderbezeichnung zugehörig sind.

3. Fernbedienungsgeber nach Anspruch 2,
**dadurch gekennzeichnet, dass**
die Taste eine OK-Taste (13) ist.

4. Fernbedienungsgeber nach einem der vorhergehenden Ansprüche,
**dadurch gekennzeichnet, dass**
der Mikrocomputer (2) derart programmiert ist, dass er bei Betätigung einer ersten vorgegebenen Taste oder Tastenkombination des Fernbedienungsgebers einen Senderbezeichnungsanzeigemodus einleitet.

5. Fernbedienungsgeber nach einem der vorhergehenden Ansprüche,
**dadurch gekennzeichnet, dass**
er weiterhin einen Eingangsanschluss aufweist, über welchen ihm die den Senderbezeichnungen entsprechenden Daten zuführbar sind.

6. Fernbedienungsgeber nach Anspruch 5,
**dadurch gekennzeichnet, dass**
der Eingangsanschluss ein Infrarotempfänger (6) ist.

7. Fernbedienungsgeber nach Anspruch 5,
**dadurch gekennzeichnet, dass**
der Eingangsanschluss eine Anschlussbuchse (7) ist.

8. Fernbedienungsgeber nach einem der Ansprüche 5-7,
**dadurch gekennzeichnet, dass**
der Mikrocomputer (2) derart programmiert ist, dass er bei Betätigung einer zweiten vorgegebenen Taste oder Tastenkombination des Fernbedienungsgebers ein Infrarotbefehlssignal aussendet, aufgrund dessen ein vom Fembedienungsgeber gesteuertes Gerät Datensignale an den Eingangsanschluss des Fernbedienungsgebers übermittelt, die den Senderbezeichnungen entsprechen.

9. Fernbedienungsgeber nach Anspruch 8,
**dadurch gekennzeichnet, dass**
die Datensignale Informationen über Programmplatznummern enthalten.

10. Fernbedienungsgeber nach einem der vorhergehenden Ansprüche,
**dadurch gekennzeichnet, dass**
jeder der Zifferntasten (11) ein oder mehrere Buchstaben des Alphabets zugeordnet sind und die Senderbezeichnungen in einem manuellen Eingabemodus mittels der Zifferntasten des Fernbedienungsgebers eingebbar sind.

11. Fernbedienungsgeber nach Anspruch 10,
**dadurch gekennzeichnet,dass**
der Mikrocomputer (2) derart programmiert ist, dass er bei Betätigung einer dritten vorgegebenen Taste oder Tastenkombination des Fernbedienungsgebers den manuellen Eingabemodus einleitet.

12. Fernbedienungsgeber nach einem der vorhergehenden Ansprüche,
**dadurch gekennzeichnet, dass**
die Steuertasten Cursorsteuertasten (12) sind und dass mittels der Cursorsteuertasten ein Blättern durch die abgespeicherten Senderbezeichnungen durchführbar ist.

13. Fernbedienungsgeber nach Anspruch 12,
**dadurch gekennzeichnet, dass**
die Senderbezeichnungen im nichtflüchtigen Speicher (3) in alphabetischer Reihenfolge abgespeichert sind.

14. Fernbedienungsgeber nach Anspruch 13,
**dadurch gekennzeichnet, dass**
durch eine Betätigung einer der Cursorsteuertasten (12) eine Anzeige einer Senderbezeichnung auslösbar ist, deren Anfangsbuchstabe im Alphabet vor oder nach dem Anfangsbuchstaben einer momentan angezeigten Senderbezeichnung liegt.

15. Fernbedienungsgeber nach Anspruch 13 oder 14,
**dadurch gekennzeichnet, dass**
durch eine Betätigung einer Cursorsteuertaste (12) eine Anzeige einer Senderbezeichnung auslösbar ist, deren Anfangsbuchstabe mit dem Anfangsbuchstaben einer momentan angezeigten Senderbezeichnung übereinstimmt.

16. Fernbedienungsgeber nach einem der vorhergehenden Ansprüche,
**dadurch gekennzeichnet, dass**
die Reihenfolge der im nichtflüchtigen Speicher (3) abgespeicherten, Senderbezeichnungen entsprechenden Daten mittels der Tasten des Fernbedienungsgebers veränderbar ist.

17. Fernbedienungsgeber nach einem der Ansprüche 4-16,
**dadurch gekennzeichnet, dass**
der Mikrocomputer (2) derart programmiert ist, dass er im Senderanzeigemodus bei Eingabe eines Buchstabens mittels der Tastatur des Fernbedienungsgebers den nichtflüchtigen Speicher (3) derart adressiert, dass eine mit dem eingegebenen Buchstaben beginnende Senderbezeichnung aus dem nichtflüchtigen Speicher (3) ausgelesen und auf dem Display (4) dargestellt wird.

## Claims

1. Remote control device, which comprises number buttons, control buttons, a microcomputer, a display and an infrared transmitter and a nonvolatile memory (3) for the storage of data corresponding to broadcaster identities,
**characterised in that**
the broadcaster identities can be represented in graphical form as a logo on the display (4).

2. Remote control device according to Claim 1,
**characterised in that**
it comprises a button which, when pressed, leads to the sending of an infrared command signal comprising channel switching data, which channel switching data are associated with a broadcaster identity currently represented on the display (4).

3. Remote control device according to Claim 2,
**characterised in that**
the button is an OK button (13).

4. Remote control device according to one of the preceding claims,
**characterised in that**
the microcomputer (2) is programmed so that it activates a broadcaster identity display mode when a first predetermined button or button combination of the remote control device is pressed.

5. Remote control device according to one of the preceding claims,
**characterised in that**
it furthermore comprises an input connection, via which the data corresponding to the broadcaster identities can be delivered to it.

6. Remote control device according to Claim 5,
**characterised in that**
the input connection is an infrared receiver (6).

7. Remote control device according to Claim 5,
**characterised in that**
the input connection is a connection socket (7).

8. Remote control device according to one of claims 5-7,
**characterised in that**
the microcomputer (2) is programmed so that when a second predetermined button or button combination of the remote control device is pressed, it sends out an infrared command signal on the basis of which a device controlled by the remote control device sends data signals, which correspond to the broadcaster identities, to the input connection of the remote control device.

9. Remote control device according to Claim 8,
**characterised in that**
the data signals contain information about channel location numbers.

10. Remote control device according to one of the preceding claims,
**characterised in that**
one or more letters of the alphabet are assigned to each of the number buttons (11), and the broadcaster identities can be entered by means of the number buttons of the remote control device in a manual input mode.

11. Remote control device according to Claim 10,
**characterised in that**
the microcomputer (2) is programmed so that it activates the manual input mode when a third predetermined button or button combination of the remote control device is pressed.

12. Remote control device according to one of the preceding claims,
**characterised in that**
the control buttons are cursor control buttons (12), and **in that** the stored broadcaster identities can be scrawled through by means of the cursor control buttons.

13. Remote control device according to Claim 12,
**characterised in that**
the broadcaster identities are stored in alphabetical order in the nonvolatile memory (3).

14. Remote control device according to Claim 13,
**characterised in that**
displaying of a broadcaster identity, the first letter of which precedes or follows the first letter of a currently displayed broadcaster identity in the alphabet, can be activated by pressing one of the cursor control buttons (12).

15. Remote control device according to Claim 13 or 14,
**characterised in that**
displaying of a broadcaster identity, the first letter of which is the same as the first letter of a currently displayed broadcaster identity, can be activated by pressing one of the cursor control buttons (12).

16. Remote control device according to one of the preceding claims,
**characterised in that**
the order of the data stored in the nonvolatile memory (3), corresponding to broadcaster identities, can be modified by means of the buttons of the remote control device.

17. Remote control device according to one of Claims 4-16,
**characterised in that**
the microcomputer (2) is programmed so that, when a letter is entered by means of the keypad of the remote control device in the broadcaster display mode, it addresses the nonvolatile memory (3) so that a broadcaster identity beginning with the entered letter is read out from the nonvolatile memory (3) and represented on the display (4).

## Revendications

1. Télécommande, qui présente des touches numériques, des touches de commande, un micro-ordinateur, un affichage et un émetteur infrarouge et une mémoire non volatile (3) pour mémoriser les données correspondant à la désignation des émetteurs, **caractérisée en ce que** la désignation des émetteurs peut être affichée sous forme graphique en tant que logo sur l'affichage (4).

2. Télécommande selon la revendication 1, **caractérisée en ce qu'**elle présente une touche, grâce à l'actionnement de laquelle un signal de commande infrarouge présentant des données de commutation de programme est envoyé, qui font partie des données de commutation de programme d'un émetteur affiché momentanément sur l'affichage (4).

3. Télécommande selon la revendication 2, **caractérisée en ce que** la touche est une touche OK (13).

4. Télécommande selon l'une des revendications précédentes, **caractérisée en ce que** le micro-ordinateur (2) est programmé de telle sorte qu'il déclenche un mode d'affichage de désignation des émetteurs par actionnement d'une première touche prédéterminée ou d'une combinaison de touches de la télécommande.

5. Télécommande selon l'une quelconque des revendications précédentes, **caractérisée en ce qu'**elle présente en outre une connexion d'entrée, grâce à laquelle les données correspondant à la désignation des émetteurs peuvent lui être délivrées.

6. Télécommande selon la revendication 5, **caractérisée en ce que** la connexion d'entrée est un récepteur infrarouge (6).

7. Télécommande selon la revendication 5, **caractérisée en ce que** la connexion d'entrée est une douille de connexion (7).

8. Télécommande selon l'une des revendications 5 à 7, **caractérisée en ce que** le micro-ordinateur (2) est programmé de sorte qu'il émet un signal d'ordre infrarouge par actionnement d'une seconde touche prédéterminée ou d'une combinaison de touches de la télécommande, grâce auquel un appareil commandé par la télécommande transmet des signaux de données à la connexion d'entrée de la télécommande, qui correspondent à la désignation des émetteurs.

9. Télécommande selon la revendication 8, **caractérisée en ce que** les signaux de données contiennent des informations concernant les numéros d'ordre de programme.

10. Télécommande selon l'une des revendications précédentes, **caractérisée en ce qu'**à chacune des touches numériques (11) sont associées une ou plusieurs lettres de l'alphabet et la désignation des émetteurs peut être saisie selon un mode de saisie manuelle grâce aux touches numériques de la télécommande.

11. Télécommande selon la revendication 10, **caractérisée en ce que** le micro-ordinateur (2) est programmé de sorte qu'il déclenche le mode de saisie manuelle par actionnement d'une troisième touche prédéterminée ou d'une combinaison de touches de la télécommande.

12. Télécommande selon l'une des revendications précédentes, **caractérisée en ce que** les touches de commande sont des touches de commande par curseur (12) et **en ce qu'**un défilement à l'écran de la désignation des émetteurs mémorisés peut être effectué grâce aux touches de commande par curseur.

13. Télécommande selon la revendication 12, **caractérisée en ce que** la désignation des émetteurs est mémorisée dans la mémoire non volatile (3) dans l'ordre alphabétique.

14. Télécommande selon la revendication 13, **caractérisée en ce qu'**un affichage de la désignation d'un émetteur, dont la première lettre se trouve dans l'alphabet avant ou après la première lettre de la désignation d'un émetteur affiché momentanément, peut être déclenché par actionnement d'une des touches de commande par curseur (12).

15. Télécommande selon la revendication 13 ou 14, **caractérisée en ce qu'**un affichage de la désignation d'un émetteur, dont la première lettre coïncide avec la première lettre de la désignation d'un émetteur momentanément affiché, peut être déclenché par actionnement d'une touche de commande par curseur (12).

16. Télécommande selon l'une des revendications précédentes, **caractérisée en ce que** la succession des données correspondant à la désignation des émetteurs et mémorisée dans la mémoire non volatile (3) peut être modifiée grâce aux touches de la télécommande.

17. Télécommande selon l'une des revendications 4 à 16, **caractérisée en ce que** le micro-ordinateur (2) est programmé de sorte qu'il adresse la mémoire non volatile (3) dans le mode d'affichage d'émetteurs lors de la saisie d'une lettre grâce au clavier de la télécommande de sorte que la désignation d'un émetteur commençant par la lettre saisie est extraite de la mémoire non volatile (3) et affichée sur l'affichage (4).
